# EUROPEAN PATENT APPLICATION

(11) **EP 4 845 031 A1**
(43) Date of publication of application: **25.11.2026**
(21) Application number: 25758299.9
(22) Date of filing: 20.02.2025
(51) Int. Cl.: H03H 17/02, B06B 1/04, G01R 23/10, G06F 3/01

(54) **SIGNAL PROCESSING CIRCUIT AND CONTROL DEVICE**

(30) Priority: 21.02.2024 JP 2024024558; 21.02.2024 JP 2024024559
(71) Applicant: MITSUMI ELECTRIC CO., LTD., Tama-shi, Tokyo 206-8567 (JP)
(72) Inventor: NGUYEN, Thi Hong Thu, Tama-shi, Tokyo 206-8567 (JP); DAN, Toru, Tama-shi, Tokyo 206-8567 (JP)
(74) Representative: Regimbeau
(86) International application number: PCT/JP2025/005782
(87) International publication number: WO 2025/178075

(57) **Abstract**

A signal processing circuit includes a filter configured to perform filter processing on an input signal; and a filter coefficient changing section configured to automatically change a coefficient of the filter according to a frequency of the input signal.

## Description

### TECHNICAL FIELD

The present invention relates to a signal processing circuit and a control device.

### BACKGROUND

Conventionally, a signal processing circuit including a low-pass filter for removing high-frequency noise from an input signal and a high-pass filter for removing the DC component from the input signal is known (for example, see Patent Document 1 below).

### Related Art Document

### Patent Document

[Patent Document 1] Japanese Laid-open Patent Application Publication No. 2009-023475

### SUMMARY OF THE INVENTION

### Problem to be Solved by the Invention

However, in a conventional signal processing circuit, when the frequency of the input signal changes, the frequency characteristic (specifically, the cutoff frequency) of the filter becomes inappropriate, and there is a possibility that the filter cannot operate normally, for example, due to an unintended phase shift in the signal.

### Means for Solving the Problem

A signal processing circuit according to an embodiment includes a filter configured to perform filter processing on an input signal; and a filter coefficient changing section configured to automatically change a coefficient of the filter according to a frequency of the input signal.

### Effect of the Invention

According to the signal processing circuit of the embodiment, the filter can operate normally even if the frequency of the input signal changes.

### BRIEF DESCRIPTION OF THE DRAWINGS

[FIG. 1] FIG. 1 is a diagram illustrating a configuration of an input device according to one embodiment.
[FIG. 2] FIG. 2 is a diagram illustrating a circuit configuration of a signal processing circuit according to one embodiment.
[FIG. 3] FIG. 3 is a diagram illustrating an example (first example) of a hardware configuration of a filter coefficient changing section included in the signal processing circuit according to one embodiment.
[FIG. 4] FIG. 4 is a graph illustrating an example (first example) of calculation of a filter coefficient by a calculating section of the filter coefficient changing section included in the signal processing circuit according to one embodiment.
[FIG. 5] FIG. 5 is a graph illustrating an example (second example) of the calculation of the filter coefficient by the calculating section of the filter coefficient changing section included in the signal processing circuit according to one embodiment.
[FIG. 6] FIG. 6 is a graph illustrating an example (first example) of a frequency characteristic of the filter coefficient calculated by the calculating section of the filter coefficient changing section included in the signal processing circuit according to one embodiment.
[FIG. 7] FIG. 7 is a graph illustrating an example (second example) of the frequency characteristic of the filter coefficient calculated by the calculating section of the filter coefficient changing section included in the signal processing circuit according to one embodiment.
[FIG. 8] FIG. 8 is a diagram illustrating an example (second example) of the hardware configuration of the filter coefficient changing section included in the signal processing circuit according to one embodiment.
[FIG. 9] FIG. 9 is a diagram illustrating a configuration of an input device according to another embodiment.
[FIG. 10] FIG. 10 is a diagram illustrating a configuration of a vibration generating device according to another embodiment.
[FIG. 11] FIG. 11 is a diagram illustrating a configuration of a frequency measuring circuit according to another embodiment.
[FIG. 12] FIG. 12 is graphs illustrating an example (first example) of calculation of a resonance frequency by the frequency measuring circuit according to another embodiment.
[FIG. 13] FIG. 13 is graphs illustrating an example (second example) of the calculation of the resonance frequency by the frequency measuring circuit according to another embodiment.
[FIG. 14] FIG. 14 is a graph illustrating a comparative example of main drive signals and sub-drive signals output from control devices.
[FIG. 15] FIG. 15 is a graph illustrating a comparative example of the sub-drive signals output from the control devices.
[FIG. 16] FIG. 16 is a graph illustrating a vibration waveform of an electromagnetic actuator when vibration of the electromagnetic actuator is braked by a sub-drive signal output from a conventional control device.
[FIG. 17] FIG. 17 is a graph illustrating a vibration waveform of the electromagnetic actuator when the vibration of the electromagnetic actuator is braked by the sub-drive signal output from a control device according to the embodiment.

### DESCRIPTION OF THE EMBODIMENTS

### [One Embodiment]

Hereinafter, one embodiment will be described with reference to the drawings.

### (Configuration of Input Device 1)

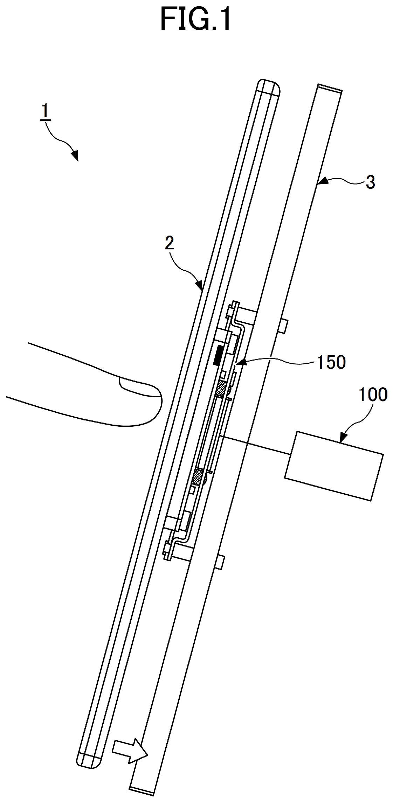

FIG. 1 is a diagram illustrating a configuration of an input device 1 according to one embodiment. The input device 1 illustrated in FIG. 1 includes a touch panel 2, a base 3, a control device 100, and an electromagnetic actuator 150.

The touch panel 2 is an example of an "operation device". The touch panel 2 is a flat member having a touch-operable operation surface on its surface. The touch panel 2 includes, for example, an electrostatic sensor including a plurality of detection electrodes, and the electrostatic sensor detects a touch operation on the operation surface performed by a finger of an operator.

The base 3 is provided on the back surface side of the touch panel 2 and is a flat member that supports the touch panel 2 and the electromagnetic actuator 150.

The control device 100 controls a vibration generating operation of the electromagnetic actuator 150 in response to a touch operation on the touch panel 2.

The electromagnetic actuator 150 is provided between the touch panel 2 and the base 3. The electromagnetic actuator 150 generates vibration to vibrate the touch panel 2, thereby presenting vibration to a finger of the operator.

### (Configuration of Vibration Generating Device 10)

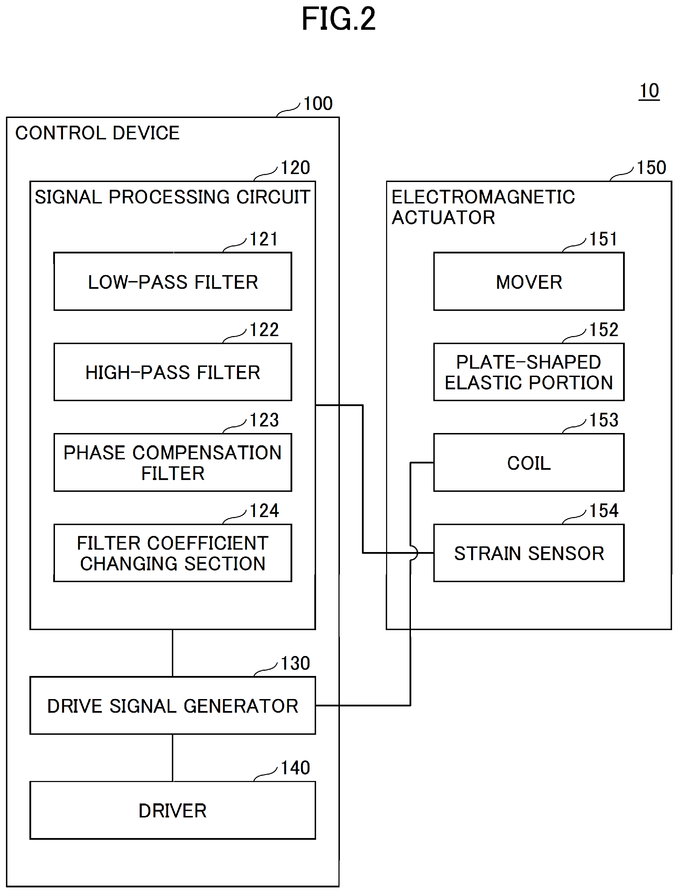

FIG. 2 is a diagram illustrating a configuration of a vibration generating device 10 according to one embodiment. In the example illustrated in FIG. 2, a signal processing circuit 120 is used in the control device 100 configured to control the electromagnetic actuator 150. However, the application of the signal processing circuit 120 is not limited to this.

As illustrated in FIG. 2, the vibration generating device 10 includes the control device 100 and the electromagnetic actuator 150. The control device 100 includes the signal processing circuit 120, a drive signal generator 130, and a driver 140.

The electromagnetic actuator 150 includes a mover 151, a plate-shaped elastic portion 152, a coil 153, and a strain sensor 154. The electromagnetic actuator 150 is configured to generate vibration by displacing the mover 151 supported by the plate-shaped elastic portion 152 when a current is supplied from the driver 140 to the coil 153.

The signal processing circuit 120 receives a detection signal detected by a strain sensor 154 (an example of a "sensor") provided in the electromagnetic actuator 150. The strain sensor 154 detects the strain of the plate-shaped elastic portion 152 caused by the displacement of the mover 151 in the electromagnetic actuator 150 and outputs a detection signal representing the detected strain of the plate-shaped elastic portion 152.

The signal processing circuit 120 performs various types of filter processing on the input detection signal. Specifically, the signal processing circuit 120 includes a low-pass filter 121, a high-pass filter 122, and a phase compensation filter 123.

The low-pass filter 121 performs, on the input detection signal, filter processing for removing high-frequency noise. The high-pass filter 122 performs, on the input detection signal, filter processing for removing a DC component. The phase compensation filter 123 performs, on the input detection signal, filter processing for adjusting the phase.

The signal processing circuit 120 outputs the detection signal after the various types of filter processing to the drive signal generator 130.

Additionally, the signal processing circuit 120 includes a filter coefficient changing section 124. The filter coefficient changing section 124 automatically changes the coefficients of respective filters (in the present embodiment, for example, the low-pass filter 121 and the high-pass filter 122) according to the frequency of the input signal. With this, when the frequency of the input signal changes, the filter coefficient changing section 124 enables the respective filters to operate normally by automatically setting appropriate coefficients corresponding to the frequency of the input signal in the respective filters. Here, the frequency of the input signal is detected by a frequency detecting section (not illustrated) provided inside or outside the signal processing circuit 120, and is input to the filter coefficient changing section 124.

The drive signal generator 130 generates a main drive signal for vibrating the electromagnetic actuator 150, and supplies the main drive signal to the driver 140 so that the driver 140 controls the coil 153 of the electromagnetic actuator 150 to vibrate the electromagnetic actuator 150.

Additionally, the drive signal generator 130 generates a sub-drive signal for braking the vibration of the electromagnetic actuator 150 by shortening the damping period of the vibration, and supplies the sub-drive signal to the driver 140 so that the driver 140 controls the coil 153 of the electromagnetic actuator 150 to brake the vibration of the electromagnetic actuator 150.

At this time, the drive signal generator 130 detects the peak timing, the bottom timing, or the zero-cross timing of the detection signal from the waveform of the detection signal input from the signal processing circuit 120. The drive signal generator 130 supplies the sub-drive signal to the driver 140 at an appropriate timing based on the detected timing of the detection signal, thereby efficiently braking the vibration of the electromagnetic actuator 150. Here, for a specific configuration for braking the vibration of the electromagnetic actuator 150, for example, a technique disclosed in Japanese Patent Application No. 2023-127739 can be used.

### (Example (First Example) of Filter Changing Processing by the Filter Coefficient Changing Section 124)

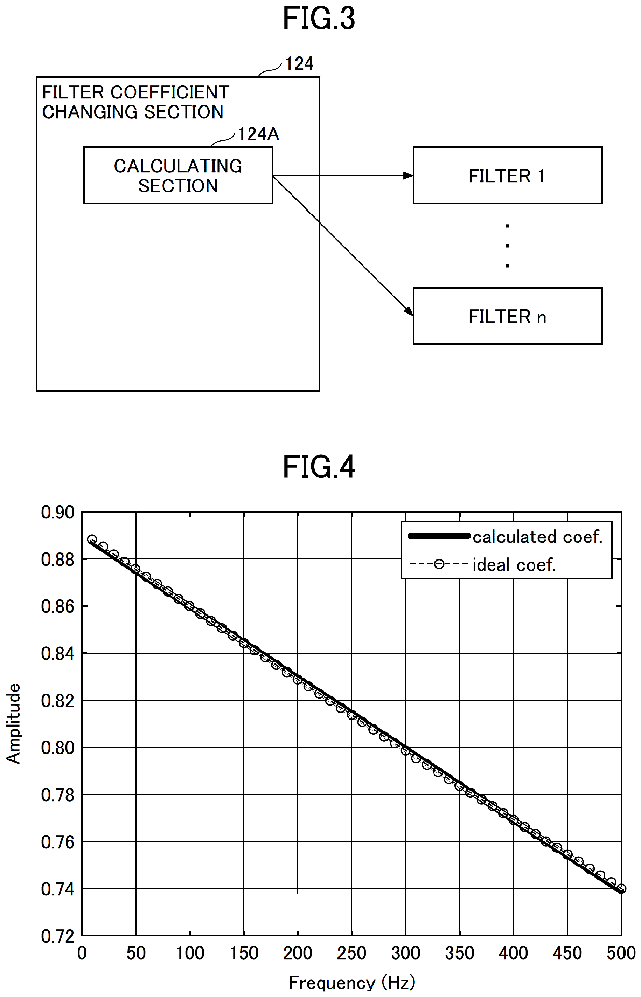

FIG. 3 is a diagram illustrating an example (first example) of a hardware configuration of the filter coefficient changing section 124 provided in the signal processing circuit 120 according to one embodiment.

In the example illustrated in FIG. 3, the filter coefficient changing section 124 includes a calculating section 124A. The calculating section 124A automatically calculates changed coefficients corresponding to the frequency of the input signal for each of the n filters (filter 1 to filter n) provided in the signal processing circuit 120, and sets the calculated coefficients.

For example, the calculating section 124A calculates the coefficients f(x) for each of the n filters (filter 1 to filter n) by the following polynomial function (1).$f \left(x\right) = {a}_{n} {x}^{n} + {a}_{n - 1} {bx}^{n - 1} + … + {a}_{0}$ (1)

Here, a₀, ..., and aₙ represent fixed constants. Additionally, x represents an input frequency.

Here, each of the low-pass filter 121 and the high-pass filter 122 has a plurality of (for example, five) coefficients. Therefore, the calculating section 124A calculates each of the plurality of coefficients of the low-pass filter 121 and each of the plurality of coefficients of the high-pass filter 122 using the polynomial function (1) and the fixed constants.

Therefore, in the signal processing circuit 120, a suitable polynomial function (1) and a fixed constant are implemented in advance for each of the plurality of coefficients of the low-pass filter 121 and each of the plurality of coefficients of the high-pass filter 122.

That is, the signal processing circuit 120 according to one embodiment only needs to implement the polynomial function (1) and the fixed constant for each filter, and thus the coefficients corresponding to the frequency of the input signal can be calculated for each of the n filters with a relatively small amount of resources.

The filter coefficient changing section 124 sets the coefficients calculated by the calculating section 124A for each of the n filters. With this, the filter coefficient changing section 124 can set appropriate coefficients corresponding to the frequency of the input signal for each of the n filters.

Here, the calculating section 124A is implemented by a digital circuit (i.e. hardware) without using a processor (i.e. software). That is, the signal processing circuit 120 according to one embodiment can automatically set suitable coefficients for the filter with a relatively small amount of resources. However, if a processor can be implemented in the signal processing circuit 120, the calculating section 124A may be implemented by a processor.

### (Calculation Example of Filter Coefficients)

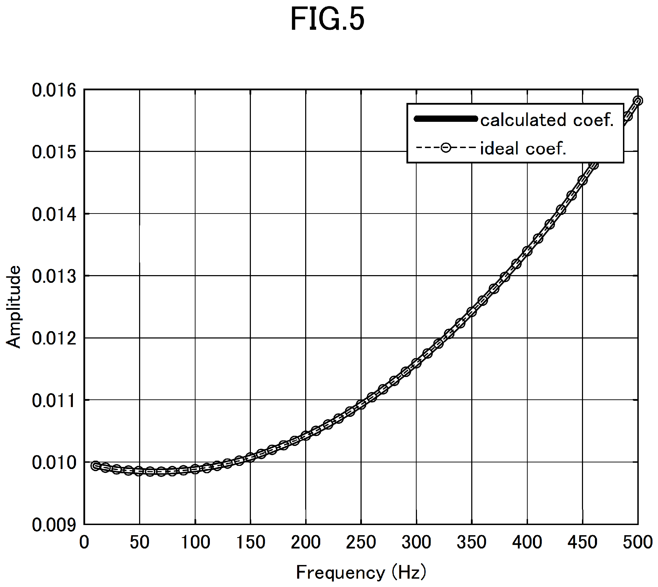

FIG. 4 is a graph illustrating a calculation example (first example) of a filter coefficient by the calculating section 124A of the filter coefficient changing section 124 included in the signal processing circuit 120 according to one embodiment. FIG. 5 is a graph illustrating a calculation example (second example) of a filter coefficient by the calculating section 124A of the filter coefficient changing section 124 included in the signal processing circuit 120 according to one embodiment.

FIG. 4 illustrates a filter coefficient calculated by the calculating section 124A of the filter coefficient changing section 124 using a first-order polynomial function in comparison with an ideal filter coefficient.

FIG. 5 illustrates a filter coefficient calculated by the calculating section 124A of the filter coefficient changing section 124 using a second-order polynomial function in comparison with an ideal filter coefficient.

Here, in the graphs illustrated in FIGS. 4 and 5, the solid lines indicate the coefficient calculated by the calculating section 124A for the frequency of the input signal, and circle plots indicate the ideal coefficient for the frequency of the input signal.

As illustrated in FIGS. 4 and 5, in the signal processing circuit 120 according to one embodiment, the calculating section 124A of the filter coefficient changing section 124 calculates the filter coefficient using the first-order polynomial function or the second-order polynomial function, so that the filter coefficient can be made equal to the ideal coefficient.

Here, the calculating section 124A needs to calculate the plurality of coefficients of the low-pass filter 121 and the plurality of coefficients of the high-pass filter 122, and it is preferable to select in advance which of the first-order polynomial function or the second-order polynomial function is to be used for each of the plurality of coefficients in accordance with the characteristics of the filter coefficients based on the results of simulation or the like.

Here, the order of the polynomial function for each of the plurality of coefficients may be selected manually by an operator, or may be automatically selected by a processing section (not illustrated) provided inside or outside the signal processing circuit 120 based on the results of simulation or the like.

### (Example of Frequency Characteristics of Filter Coefficients)

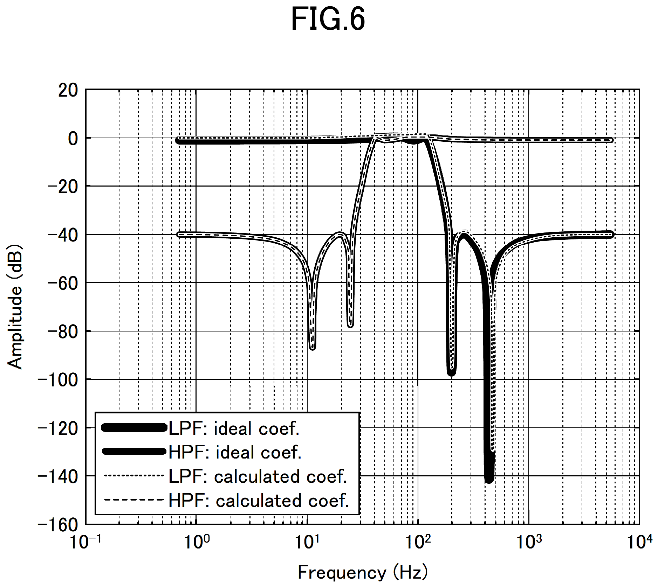

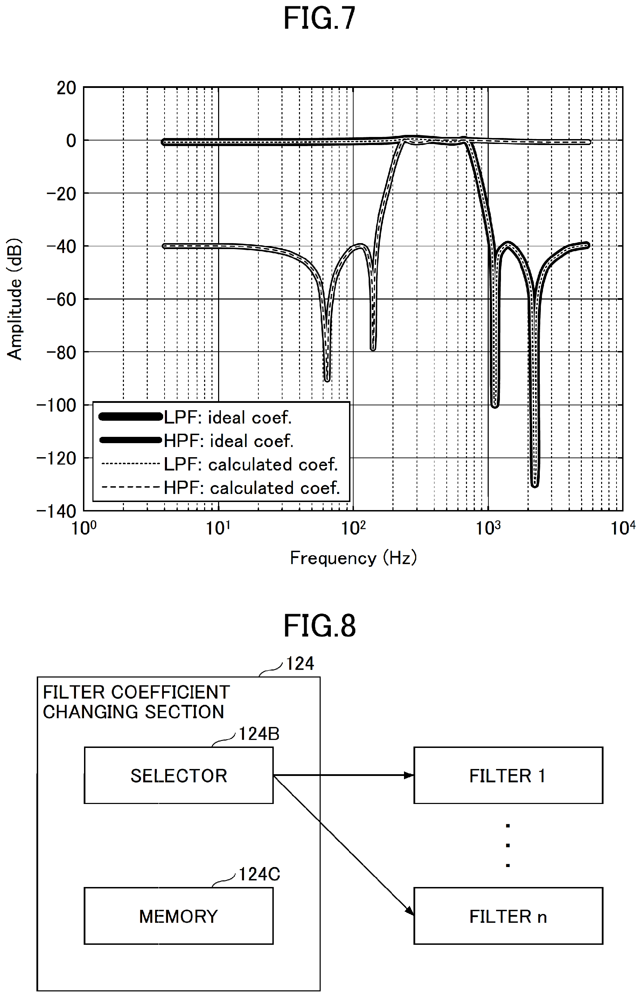

FIG. 6 is a graph illustrating an example (first example) of frequency characteristics of filter coefficients calculated by the calculating section 124A of the filter coefficient changing section 124 provided in the signal processing circuit 120 according to one embodiment. FIG. 7 is a graph illustrating an example (second example) of frequency characteristics of filter coefficients calculated by the calculating section 124A of the filter coefficient changing section 124 provided in the signal processing circuit 120 according to one embodiment.

FIG. 6 illustrates the frequency characteristics of the coefficients of one low-pass filter 121 and one high-pass filter 122 calculated by the calculating section 124A of the filter coefficient changing section 124 in comparison with frequency characteristics of coefficients of ideal filters.

FIG. 7 illustrates the frequency characteristics of the coefficients of another low-pass filter 121 and another high-pass filter 122 calculated by the calculating section 124A of the filter coefficient changing section 124 in comparison with frequency characteristics of ideal filters.

Here, in the graphs illustrated in FIGS. 6 and 7, the dotted lines indicate the frequency characteristics of the coefficients calculated by the calculating section 124A, and the solid lines indicate the frequency characteristics of the ideal filters.

As illustrated in FIGS. 6 and 7, in the signal processing circuit 120 according to one embodiment, the calculating section 124A of the filter coefficient changing section 124 calculates the coefficients of the filter using the first-order polynomial function or the second-order polynomial function, so that the frequency characteristics of the coefficients of the filter can be made equal to the ideal frequency characteristics.

### (Example (Second Example) of Filter Changing Processing by Filter Coefficient Changing Section 124)

FIG. 8 is a diagram illustrating an example (second example) of the hardware configuration of the filter coefficient changing section 124 provided in the signal processing circuit 120 according to one embodiment.

In the example illustrated in FIG. 8, the filter coefficient changing section 124 includes a selector 124B and a memory 124C.

The memory 124C stores a plurality of suitable coefficients for each frequency range of the input signal for each of the n filters (filter 1 to filter n) provided in the signal processing circuit 120. The plurality of coefficients stored in the memory 124C are obtained in advance based on the results of simulation or the like, and are suitable for operating the filters normally.

The selector 124B selects coefficients corresponding to the frequency of the input signal from among the plurality of coefficients stored in the memory 124C for each of the n filters (filter 1 to filter n) provided in the signal processing circuit 120.

That is, the signal processing circuit 120 according to one embodiment only needs to implement a table in which the plurality of coefficients are set in the memory 124C, and thus the coefficients corresponding to the frequency of the input signal can be calculated for each of the n filters with a relatively small amount of resources.

The filter coefficient changing section 124 sets the coefficients selected by the selector 124B for each of the n filters. With this, the filter coefficient changing section 124 can set appropriate coefficients corresponding to the frequency of the input signal for each of the n filters.

Here, each of the low-pass filter 121 and the high-pass filter 122 has the plurality of coefficients (for example, five). Therefore, the selector 124B selects each of the plurality of coefficients of the low-pass filter 121 and each of the plurality of coefficients of the high-pass filter 122 from among the plurality of coefficients stored in the memory 124C.

Accordingly, a plurality of suitable coefficients for each frequency of the input signal are set in advance in the memory 124C for each of the plurality of coefficients of the low-pass filter 121 and each of the plurality of coefficients of the high-pass filter 122.

Additionally, the selector 124B is implemented by a digital circuit (i.e. hardware) without using a processor (i.e. software). That is, the signal processing circuit 120 according to one embodiment can automatically set suitable coefficients for the filter with a relatively small amount of resources. However, if a processor can be mounted in the signal processing circuit 120, the selector 124B may be implemented by a processor.

### [Another Embodiment]

Hereinafter, another embodiment will be described with reference to the drawings.

Conventionally, a technique for detecting a zero-cross of a signal to be measured and measuring the frequency of the signal to be measured based on a result of the detection has been disclosed (for example, see Japanese Laid-open Patent Application Publication No. 2013-145146).

However, when the conventional technique is used for brake control of a vibration generating device, for example, the signal to be measured suddenly stops when the vibration generating device is suddenly braked, and thus the frequency of the signal to be measured cannot be accurately measured. Therefore, the measured value of the resonance frequency used for the brake control of the vibration generating device may be updated with an inappropriate measured value.

A frequency measuring circuit according to another embodiment is a frequency measuring circuit configured to measure the resonance frequency of a vibration detection signal output from a sensor for detecting vibration of the vibration generating device, and includes a frequency calculating section configured to calculate the measured value of the resonance frequency, and a frequency update determining section configured to determine, based on the measured value calculated by the frequency calculating section, whether to update the measured value used for the brake control of the vibration generating device with the measured value calculated by the frequency calculating section.

According to the frequency measuring circuit according to another embodiment, it can be determined whether to update the measured value used for the brake control of the vibration generating device according to the measured value of the resonance frequency, thereby preventing the measured value of the resonance frequency used for the brake control of the vibration generating device from being updated with an inappropriate measured value.

### (Configuration of Input Device 1)

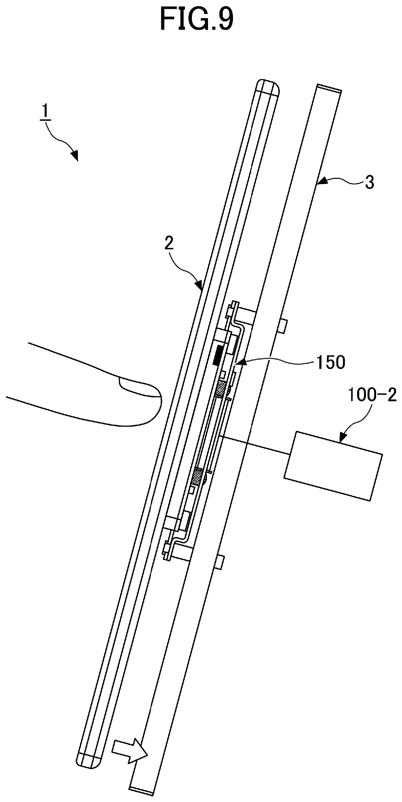

FIG. 9 is a diagram illustrating a configuration of an input device 1 according to another embodiment. The input device 1 illustrated in FIG. 9 includes the touch panel 2, the base 3, a control device 100-2, and the electromagnetic actuator 150.

The touch panel 2 is an example of an "operation device". The touch panel 2 is a flat member having a touch-operable operation surface on its surface. The touch panel 2 includes, for example, an electrostatic sensor including a plurality of detection electrodes, and the electrostatic sensor detects a touch operation on the operation surface by a finger of an operator.

The base 3 is provided on the back surface side of the touch panel 2 and is a flat member that supports the touch panel 2 and the electromagnetic actuator 150.

The control device 100-2 controls a vibration generating operation of the electromagnetic actuator 150 in response to a touch operation on the touch panel 2.

The electromagnetic actuator 150 is provided between the touch panel 2 and the base 3. The electromagnetic actuator 150 generates vibration to vibrate the touch panel 2, thereby presenting vibration to a finger of the operator.

### (Equation of Motion of Damped Spring Vibration)

Here, the equation of motion of damped spring vibration will be described.

When a viscous resistance proportional to the velocity is present, the following equation (1) holds. Here, Kₛₚ is the spring constant [N/M], and D is the damping constant [N/(m/s)].

[Math. 1] $F = - {K}_{sp} x \left(t\right) - D v \left(t\right)$ (1)

Additionally, the equation of motion of an object of mass m is expressed by the following equation (2):

[Math. 2] $m \left(\frac{{d}^{2}}{{dt}^{2}} x\left(t\right)\right) = - {K}_{sp} x \left(t\right) - D \left(\frac{d}{dt} x\left(t\right)\right)$ (2)

Here, when the following equations (3) and (4) are used, the general solution when 0<Z<1 is obtained by the following equation (5):

[Math. 3] ${ω}_{0} = \sqrt{\frac{{K}_{sp}}{m}}$ (3)

[Math. 4] $Z = \frac{D}{2 \sqrt{{K}_{sp} m}}$ (4)

[Math. 5] $x \left(t\right) = {Ce}^{- {Zω}_{0} t} cos \left({ω}_{0}\sqrt{1 - {Z}^{2}}t-α\right)$ (5)

Note that w_{d} and f_{d} obtained by the following equations (6) and (7) are referred to as the damped natural angular frequency and the damped natural frequency, respectively.

[Math. 6] ${ω}_{d} = {ω}_{0} \sqrt{1 - {Z}^{2}}$ (6)

[Math. 7] ${f}_{d} = \frac{{ω}_{d}}{2 π}$ (7)

### (Configuration of Vibration Generating Device 10)

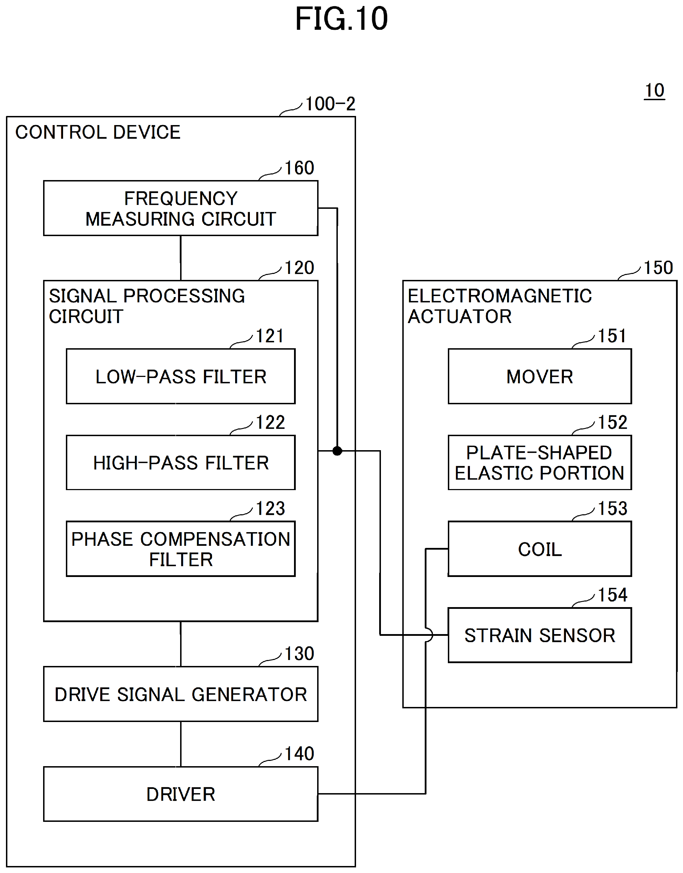

FIG. 10 is a diagram illustrating a configuration of a vibration generating device 10 according to another embodiment. In the example illustrated in FIG. 10, the signal processing circuit 120 is used in the control device 100-2 configured to control the electromagnetic actuator 150. However, the application of the signal processing circuit 120 is not limited to this.

As illustrated in FIG. 10, the vibration generating device 10 includes the control device 100-2 and the electromagnetic actuator 150. The control device 100-2 includes the signal processing circuit 120, the drive signal generator 130, a driver 140, and a frequency measuring circuit 160.

The electromagnetic actuator 150 includes the mover 151, the plate-shaped elastic portion 152, the coil 153, and the strain sensor 154. The electromagnetic actuator 150 is configured to generate vibration by displacing the mover 151 supported by the plate-shaped elastic portion 152 when a current is supplied from the driver 140 to the coil 153.

The signal processing circuit 120 receives a detection signal detected by the strain sensor 154 (an example of a "sensor") provided in the electromagnetic actuator 150. The strain sensor 154 detects the strain of the plate-shaped elastic portion 152 caused by the displacement of the mover 151 in the electromagnetic actuator 150, and outputs a detection signal representing the detected strain of the plate-shaped elastic portion 152.

The signal processing circuit 120 performs various types of filter processing on the input detection signal. Specifically, the signal processing circuit 120 includes the low-pass filter 121, the high-pass filter 122, and the phase compensation filter 123.

The low-pass filter 121 performs, on the input detection signal, filter processing for removing high-frequency noise. The high-pass filter 122 performs, on the input detection signal, filter processing for removing a DC component. The phase compensation filter 123 performs, on the input detection signal, filter processing for adjusting the phase.

The signal processing circuit 120 outputs the detection signal obtained after various types of filter processing to the drive signal generator 130.

The drive signal generator 130 generates a main drive signal for vibrating the electromagnetic actuator 150 and supplies the main drive signal to the driver 140 so that the driver 140 controls the coil 153 of the electromagnetic actuator 150 to vibrate the electromagnetic actuator 150.

Additionally, the drive signal generator 130 generates a sub-drive signal for braking the vibration of the electromagnetic actuator 150 by shortening the damping period of the vibration, and supplies the sub-drive signal to the driver 140 so that the driver 140 controls the coil 153 of the electromagnetic actuator 150 to brake the vibration of the electromagnetic actuator 150.

At this time, the drive signal generator 130 detects the peak timing, the bottom timing, or the zero-cross timing of the detection signal from the waveform of the detection signal input from the signal processing circuit 120. The drive signal generator 130 supplies the sub-drive signal to the driver 140 at an appropriate timing based on the detected timing of the detection signal, thereby efficiently braking the vibration of the electromagnetic actuator 150.

Here, as illustrated in FIG. 10, the control device 100-2 includes the frequency measuring circuit 160. The frequency measuring circuit 160 measures the resonance frequency of a signal input from the strain sensor 154 to the signal processing circuit 120. The frequency measuring circuit 160 outputs the measured value of the resonance frequency to the subsequent signal processing circuit 120 or the like. With this, the measured value of the resonance frequency measured by the frequency measuring circuit 160 is used for brake control of the electromagnetic actuator 150 by the control device 100-2. By using the measured value of the resonance frequency measured by the frequency measuring circuit 160 with high accuracy, the control device 100-2 can perform the brake control of the electromagnetic actuator 150 with high accuracy at an appropriate timing corresponding to the actual resonance frequency of the electromagnetic actuator 150.

Specifically, when the same frequency as the vibration frequency of the electromagnetic actuator 150 is set in the algorithm, the control device 100-2 correctly outputs a brake signal for canceling the vibration of the electromagnetic actuator 150 and can rapidly attenuate the vibration of the electromagnetic actuator 150.

Conversely, when a frequency different from the vibration frequency of the electromagnetic actuator 150 is set in the algorithm, or when the vibration frequency of the electromagnetic actuator 150 is different from the frequency set in the algorithm due to the fluctuations of the clock frequency of the IC in the control device 100-2, the brake signal for canceling the vibration of the electromagnetic actuator 150 cannot be correctly output, and the vibration of the electromagnetic actuator 150 can be gradually attenuated but not rapidly attenuated.

Therefore, in order to efficiently attenuate the vibration of the electromagnetic actuator 150 even when the vibration frequency of the electromagnetic actuator 150 is different from the frequency set in the algorithm, the control device 100-2 always measures the vibration frequency of the electromagnetic actuator 150 with high accuracy in the background by the frequency measuring circuit 160 and updates the frequency set in the algorithm to the measured vibration frequency.

Here, with respect to a specific configuration for braking the vibration of the electromagnetic actuator 150, for example, a technique disclosed in Japanese Patent Application No. 2023-127739 can be used.

### (Configuration of Frequency Measuring Circuit 160)

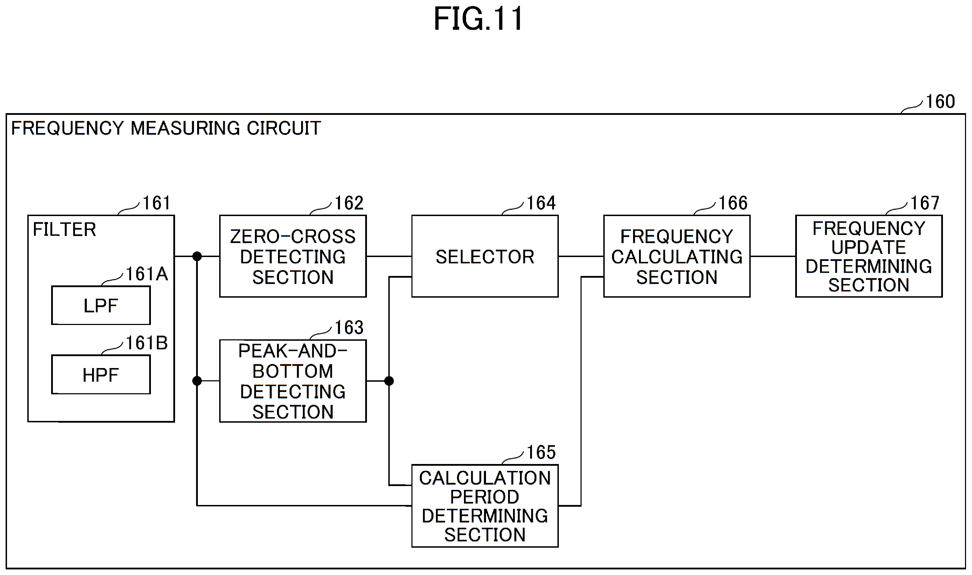

FIG. 11 is a diagram illustrating a configuration of the frequency measuring circuit 160 according to another embodiment. As illustrated in FIG. 11, the frequency measuring circuit 160 includes a filter 161, a zero-cross detecting section 162, a peak-and-bottom detecting section 163, a selector 164, a calculation period determining section 165, a frequency calculating section 166, and a frequency update determining section 167.

The filter 161 performs filter processing for removing a specific frequency component of the input signal. Specifically, the filter 161 includes a low-pass filter 161A for removing high-frequency noise of the input signal and a high-pass filter 161B for removing a DC component of the input signal.

The zero-cross detecting section 162 detects a zero-cross point from the signal filtered by the filter 161.

The peak-and-bottom detecting section 163 detects a peak point and a bottom point from the signal filtered by the filter 161.

The selector 164 selects the zero-cross point detected by the zero-cross detecting section 162 or the peak point and the bottom point detected by the peak-and-bottom detecting section 163 as parameters used for calculating the resonance frequency by the frequency calculating section 166.

The calculation period determining section 165 determines a calculation period of the measured value of the resonance frequency in the input signal based on the signal filtered by the filter 161 and the peak point and the bottom point detected by the peak-and-bottom detecting section 163. In particular, the calculation period determining section 165 determines the calculation period of the measured value of the resonance frequency in the input signal according to the time required until the input signal stops. For example, the calculation period determining section 165 determines a relatively long calculation period when the input signal stops gradually and determines a relatively short calculation period when the input signal stops rapidly.

The frequency calculating section 166 calculates a measured value of the resonance frequency of the input signal based on the parameter (zero-cross point, or peak point and bottom point) selected by the selector 164 and the calculation period determined by the calculation period determining section 165. For example, the frequency calculating section 166 calculates a measured value freq of the resonance frequency of the input signal by the following equation (8). Here, t1, t2, ..., tn indicate the time periods of cycles 1, 2, ..., n. Additionally, N indicates the number of cycles.

[Math. 8] $freq = \frac{1}{\left(\frac{{t}_{1} + {t}_{2} + ⋯ + {t}_{n}}{N}\right)}$ (8)

The frequency update determining section 167 determines, based on the measured value calculated by the frequency calculating section 166, whether to update the measured value used for the brake control of the vibration generating device 10 with the measured value calculated by the frequency calculating section 166.

For example, when the measured value calculated by the frequency calculating section 166 is outside a predetermined frequency range, the frequency update determining section 167 regards the measurement time of the frequency of the input signal as being insufficient and the frequency of the input signal as being outside the predetermined frequency range due to the sufficient efficiency of the brake control, determines that "the braking force by the brake control of the vibration generating device 10 is sufficient", determines not to update the measured value used for the brake control of the vibration generating device 10, and does not output the measured value calculated by the frequency calculating section 166 to the subsequent signal processing circuit 120.

When the measured value calculated by the frequency calculating section 166 is within the predetermined frequency range, the frequency update determining section 167 regards the measurement time of the frequency of the input signal as being sufficient and the frequency of the input signal as being within the predetermined frequency range due to the insufficient efficiency of the brake control, determines that "the braking force by the brake control of the vibration generating device 10 is insufficient", and determines to update the measured value used for the brake control of the vibration generating device 10, and outputs the measured value calculated by the frequency calculating section 166 to the subsequent signal processing circuit 120.

Here, a suitable value for the predetermined frequency range is obtained in advance by simulation or the like so that the above-described determination can be performed with high accuracy.

### (Calculation Example (First Example) of Resonance Frequency)

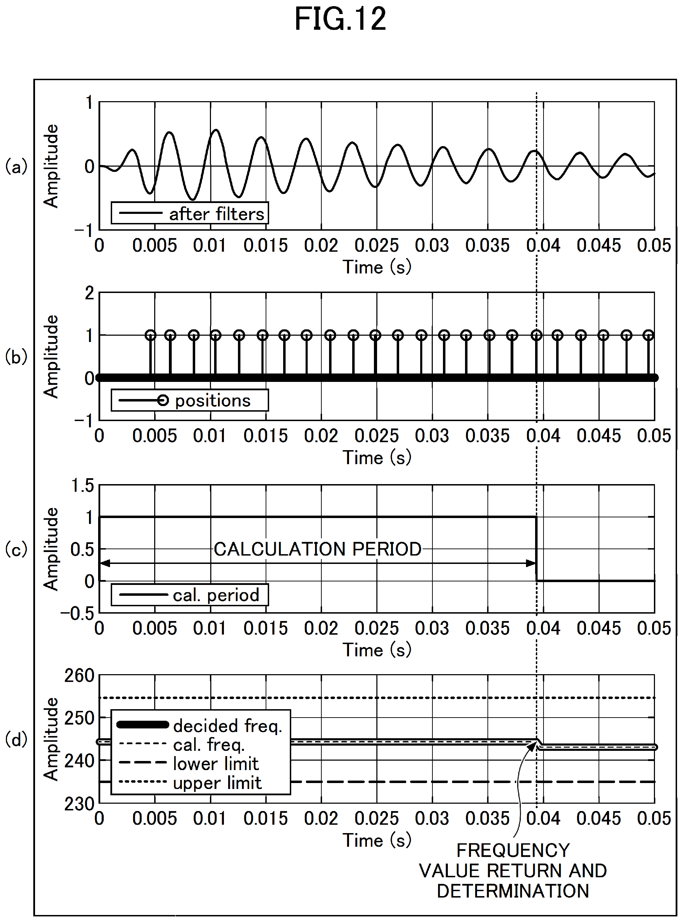

FIG. 12 is graphs illustrating a calculation example (First Example) of a resonance frequency by the frequency measuring circuit 160 according to another embodiment.

FIG. 12 illustrates an example in which, as a result of calculating the measured value of the resonance frequency of the input signal from the peak point and the bottom point of the input signal by the frequency calculating section 166, the measured value used for the brake control of the vibration generating device 10 is updated by the frequency update determining section 167.

FIG. 12 (a) illustrates the waveform of the signal filtered by the filter 161. FIG. 12 (b) illustrates the peak point and the bottom point detected by the peak-and-bottom detecting section 163. FIG. 12 (c) illustrates the calculation period determined by the calculation period determining section 165. FIG. 12 (d) illustrates the measured value of the resonance frequency calculated by the frequency calculating section 166.

In the example illustrated in FIG. 12 (a), the input signal gradually stops due to the absence of the brake control of the vibration generating device 10 or insufficient efficiency of the brake control of the vibration generating device 10. Therefore, as illustrated in FIG. 12 (c), the calculation period determining section 165 determines a relatively long calculation period until the input signal stops based on the peak point and the bottom point of the input signal illustrated in FIG. 12 (b). Then, as illustrated in FIG. 12 (d), the frequency calculating section 166 calculates the measured value of the resonance frequency of the input signal using the calculation period illustrated in FIG. 12 (c) as a calculation target.

Here, as illustrated in FIG. 12 (d), the measured value of the resonance frequency calculated by the frequency calculating section 166 is within the predetermined frequency range (that is, less than or equal to the upper limit and greater than or equal to the lower limit). This is because the number of cycles N of the input signal is sufficient because the input signal gradually stops, and the resonance frequency of the input signal can be measured with high accuracy.

In this case, the frequency update determining section 167 determines that "there is no brake control or the efficiency of the brake control is insufficient" and outputs the measured value calculated by the frequency calculating section 166 to the signal processing circuit 120, thereby updating the measured value used for the brake control of the vibration generating device 10. Therefore, the frequency measuring circuit 160 according to another embodiment can update the measured value of the resonance frequency used for the brake control of the vibration generating device 10, using the highly accurate measured value.

### (Calculation Example (Second Example) of Resonance Frequency)

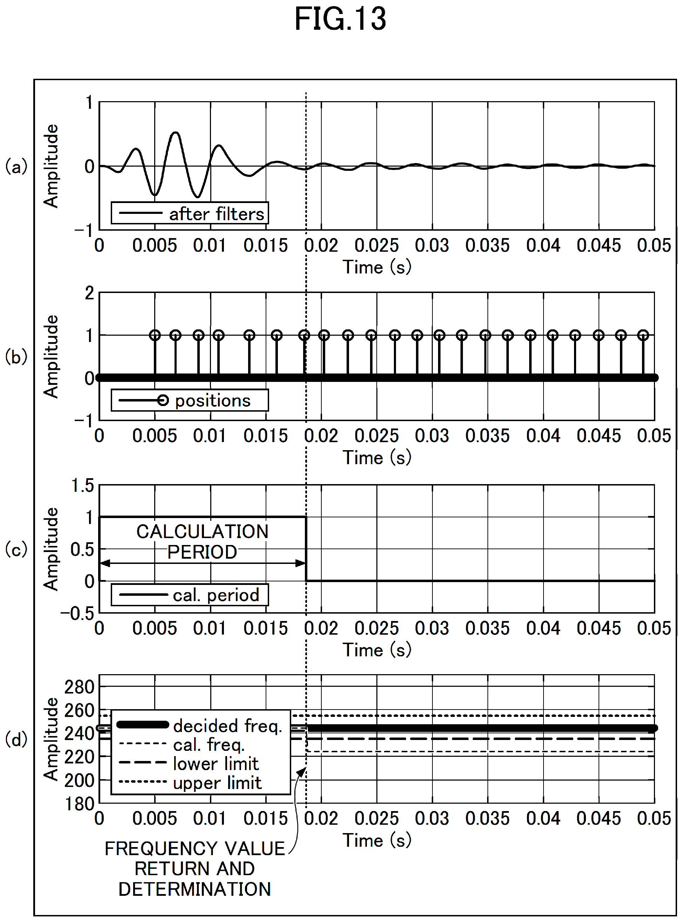

FIG. 13 is graphs illustrating a calculation example (second example) of the resonance frequency by the frequency measuring circuit 160 according to another embodiment.

FIG. 13 illustrates an example in which, as a result of calculating the measured value of the resonance frequency of the input signal from the peak point and the bottom point of the input signal by the frequency calculating section 166, the measured value used for the brake control of the vibration generating device 10 is not updated by the frequency update determining section 167.

FIG. 13 (a) illustrates the waveform of the signal filtered by the filter 161. FIG. 13 (b) illustrates the peak point and the bottom point detected by the peak-and-bottom detecting section 163. FIG. 13 (c) illustrates the calculation period determined by the calculation period determining section 165. FIG. 13 (d) illustrates the measured value of the resonance frequency calculated by the frequency calculating section 166.

In the example illustrated in FIG. 13 (a), the input signal is abruptly stopped when the vibration generating device 10 is abruptly braked. Therefore, as illustrated in FIG. 13 (c), the calculation period determining section 165 determines a relatively short calculation period until the input signal stops on the basis of the peak point and the bottom point illustrated in FIG. 13 (b). Then, as illustrated in FIG. 13 (d), the frequency calculating section 166 calculates the measured value of the resonance frequency of the input signal using the calculation period illustrated in FIG. 13 (c) as a calculation target.

Here, as illustrated in FIG. 13 (d), the measured value of the resonance frequency calculated by the frequency calculating section 166 is outside the predetermined frequency range (that is, less than the lower limit). This is because the number of cycles N of the input signal becomes insufficient because the input signal stops abruptly. In addition, when the input signal stops abruptly, it is equivalent to an increase in the damping coefficient D, Z increases from the equation (4), and the frequency measured from the equations (6) and (7) becomes relatively small.

In this case, the frequency update determining section 167 determines that "the efficiency of the brake is sufficient" and does not output the measured value calculated by the frequency calculating section 166 to the signal processing circuit 120, thereby not updating the measured value used for the brake control of the vibration generating device 10. Therefore, the frequency measuring circuit 160 according to another embodiment can prevent the measured value of the resonance frequency used for the brake control of the vibration generating device 10 from being updated with an inappropriate measured value.

Here, the frequency calculating section 166 is not limited to calculating the measured value of the resonance frequency of the input signal from the peak point and bottom point of the input signal detected by the peak-and-bottom detecting section 163, but may also calculate the measured value of the resonance frequency of the input signal from the zero-cross point of the input signal detected by the zero-cross detecting section 162.

As described above, the frequency measuring circuit 160 according to another embodiment is the frequency measuring circuit 160 configured to measure the resonance frequency of the vibration detection signal output from the sensor configured to detect vibration of the vibration generating device 10, and includes the frequency calculating section 166 configured to calculate the measured value of the resonance frequency, and the frequency update determining section 167 configured to determine, based on the measured value calculated by the frequency calculating section 166, whether to update the measured value used for the brake control of the vibration generating device 10 with the measured value calculated by the frequency calculating section 166.

With this, the frequency measuring circuit 160 according to another embodiment can determine whether to update the measured value used for brake control of the vibration generating device 10 according to the measured value of the resonance frequency, thereby preventing the measured value of the resonance frequency used for the brake control of the vibration generating device 10 from being updated with an inappropriate measured value.

Additionally, in the frequency measuring circuit 160 according to another embodiment, the frequency update determining section 167 determines not to update the measured value used for the brake control of the vibration generating device 10 when the measured value calculated by the frequency calculating section 166 is outside the predetermined frequency range, and determines to update the measured value used for the brake control of the vibration generating device 10 when the measured value calculated by the frequency calculating section 166 is within the predetermined frequency range.

With this, the frequency measuring circuit 160 according to another embodiment can determine whether to update the measured value used for the brake control of the vibration generating device 10 with a relatively simple configuration.

Additionally, the frequency measuring circuit 160 according to another embodiment includes the calculation period determining section 165 configured to determine the calculation period of the measured value in the input signal according to the time required until the input signal stops, and the frequency calculating section 166 calculates the measured value using the calculation period determined by the calculation period determining section 165 as the calculation target.

With this, the frequency measuring circuit 160 according to another embodiment can calculate the measured value in an appropriate calculation period according to the time required until the input signal stops.

Additionally, the frequency measuring circuit 160 according to another embodiment includes the zero-cross detecting section 162 configured to detect the zero-cross point in the detection signal, the calculation period determining section 165 determines the calculation period corresponding to the time required until the detection signal stops based on the zero-cross point detected by the zero-cross detecting section 162, and the frequency calculating section 166 calculates the measured value based on the zero-cross point detected by the zero-cross detecting section 162 in the calculation period determined by the calculation period determining section 165.

With this, the frequency measuring circuit 160 according to another embodiment can appropriately determine the calculation period of the measured value based on the zero-cross point in the detection signal and calculate the measured value with high accuracy.

Additionally, the frequency measuring circuit 160 according to another embodiment includes the peak-and-bottom detecting section 163 configured to detect the peak point and the bottom point in the detection signal, the calculation period determining section 165 determines the calculation period corresponding to the time required until the detection signal stops based on the peak point and the bottom point detected by the peak-and-bottom detecting section 163, and the frequency calculating section 166 calculates the measured value based on the peak point and the bottom point detected by the peak-and-bottom detecting section 163 in the calculation period determined by the calculation period determining section 165.

With this, the frequency measuring circuit 160 according to another embodiment can appropriately determine the calculation period of the measured value based on the peak point and the bottom point in the detection signal and calculate the measured value with high accuracy.

### [Comparative Example]

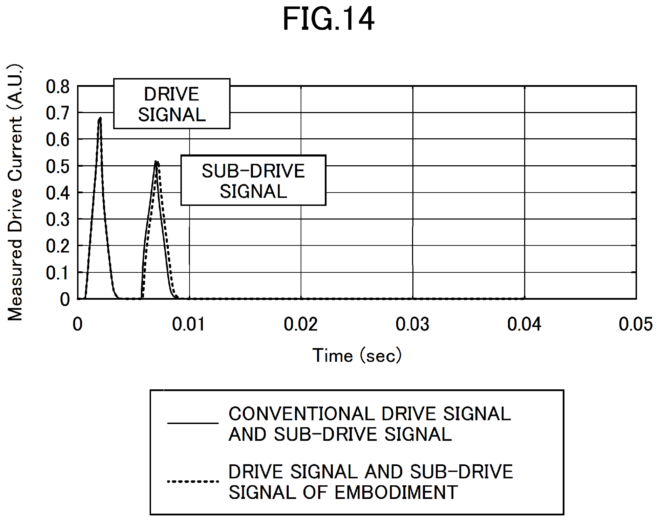

Hereinafter, with reference to FIGS. 14 to 17, a comparative example of the waveform of the drive signal and the brake effect of the electromagnetic actuator using a conventional control device and the control device 100-2 according to another embodiment will be described.

Here, the control device 100 used in the comparative example has both the function of the control device 100 according to one embodiment (that is, the function of automatically changing the filter coefficient according to the frequency of the input signal) and the function of the control device 100-2 according to another embodiment (that is, the function of measuring the resonance frequency with high accuracy).

### (Example of Main Drive Signal and Sub-drive Signal)

FIG. 14 is a graph illustrating a comparative example of the main drive signal and the sub-drive signal output from the control device.

As illustrated in FIG. 14, both the conventional control device and the control device 100 according to the embodiment output the main drive signal for vibrating the electromagnetic actuator and then output the sub-drive signal for braking the vibration of the electromagnetic actuator.

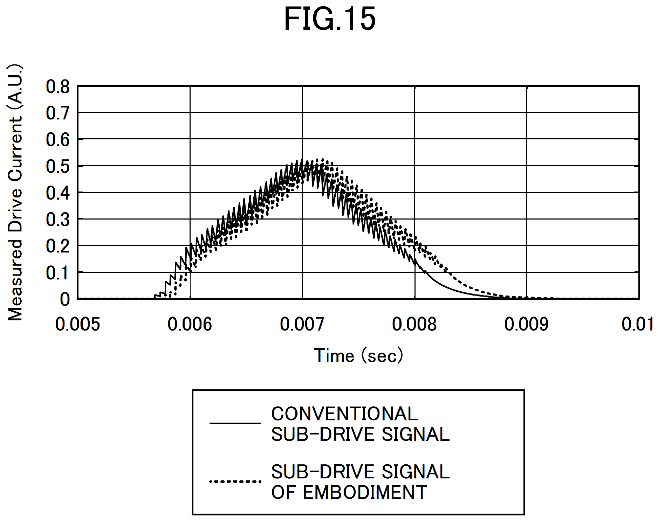

FIG. 15 is a graph illustrating a comparative example of the sub-drive signal output from the control device. FIG. 15 is an enlarged view of the sub-drive signal illustrated in FIG. 14. Here, FIG. 15 also illustrates the sub-drive signal for the electromagnetic actuator when the vibration frequency of the electromagnetic actuator shifts to a lower side by 5%. As illustrated in FIG. 15, the waveform of the sub-drive signal for the electromagnetic actuator when the vibration frequency of the electromagnetic actuator shifts to a lower side by 5%, which is output from the control device 100 according to the embodiment (dotted line in the figure), shifts on the time axis and changes in time duration with respect to the waveform of the sub-drive signal output from the conventional control device (solid line in the figure).

This is because, when the vibration frequency of the electromagnetic actuator shifts to a lower side by 5%, the sub-drive signal output from the control device 100 measures the resonance frequency with high accuracy as described in another embodiment, and also automatically changes the coefficient of the filter according to the frequency of the input signal as described in one embodiment.

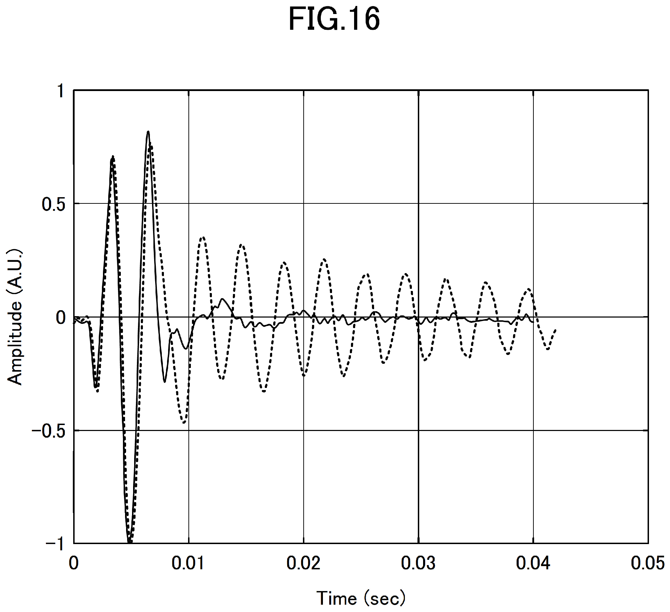

FIG. 16 is a graph illustrating the vibration waveform of the electromagnetic actuator when the vibration of the electromagnetic actuator is braked by the sub-drive signal output from the conventional control device. Here, FIG. 16 illustrates an example of the vibration waveform of the electromagnetic actuator when the vibration frequency of the electromagnetic actuator shifts to a lower side by 5%. Here, in FIG. 16, the solid line illustrates the vibration waveform of the electromagnetic actuator 150 when a brake is appropriately applied to the electromagnetic actuator 150 having no vibration frequency shift, and the dotted line illustrates the vibration waveform of the electromagnetic actuator when the vibration of the electromagnetic actuator 150 having a vibration frequency shifted to a lower side by 5% is braked by the sub-drive signal output from the conventional control device.

Because the conventional control device does not measure the resonance frequency with high accuracy, the coefficient of the filter is not appropriately adjusted. Therefore, as illustrated in FIG. 16, when the vibration frequency of the electromagnetic actuator shifts to a lower side by 5% and the vibration of the electromagnetic actuator is braked by the sub-drive signal (see the solid line in FIG. 15) output from the conventional control device, the brake cannot be applied to the electromagnetic actuator at an appropriate timing and within an appropriate time duration, and the residual vibration of the electromagnetic actuator cannot converge in a short time.

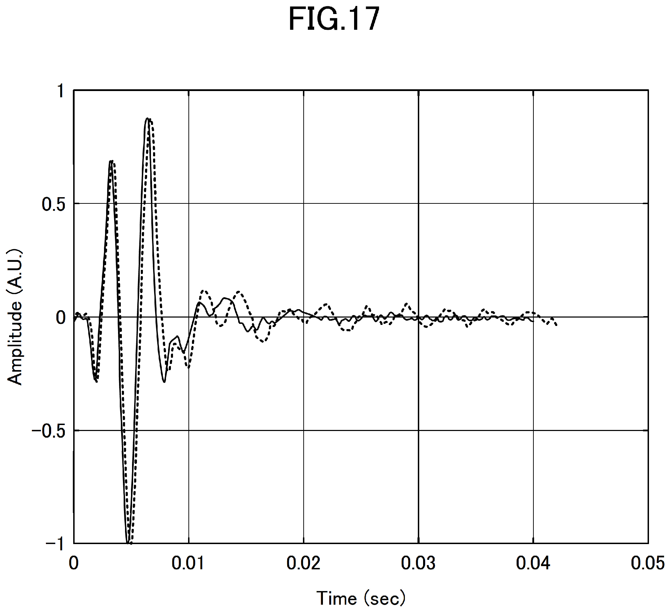

FIG. 17 is a graph illustrating the vibration waveform of the electromagnetic actuator 150 when the vibration of the electromagnetic actuator 150 is braked by the sub-drive signal output from the control device 100 according to the embodiment. Here, FIG. 17 illustrates an example of the vibration waveform of the electromagnetic actuator 150 when the vibration frequency of the electromagnetic actuator 150 shifts to a lower side by 5%. Here, in FIG. 17, the solid line illustrates the vibration waveform of the electromagnetic actuator 150 when the brake is appropriately applied to the electromagnetic actuator 150 having no vibration frequency shift, and the dotted line illustrates the vibration waveform of the electromagnetic actuator 150 when the vibration of the electromagnetic actuator 150 having a vibration frequency shifted to a lower side by 5% is braked by the sub-drive signal output from the control device 100 according to the embodiment.

The control device 100 according to the embodiment can measure the resonance frequency with high accuracy and adjust the coefficients of the filter appropriately. Therefore, as illustrated in FIG. 17, when the vibration frequency of the electromagnetic actuator 150 shifts to a lower side by 5% and the vibration of the electromagnetic actuator 150 is braked by the sub-drive signal output from the control device 100 according to the embodiment (see the dotted line in FIG. 15), the brake can be applied to the electromagnetic actuator 150 at an appropriate timing and within an appropriate time duration, and the residual vibration of the electromagnetic actuator 150 can converge in a short time.

As described above, because the control device 100 according to the embodiment can measure the resonance frequency with high accuracy, and further, automatically change the coefficients of the filter according to the frequency of the input signal, the waveform of the sub-drive signal applied to the electromagnetic actuator 150 can be adjusted appropriately, thereby improving the braking effect of the electromagnetic actuator 150.

Therefore, for example, when the waveform of the sub-drive signal output from a certain control device is adjusted similarly to the waveform of the sub-drive signal output from the control device 100 according to the embodiment illustrated in FIG. 15, or when the residual vibration of the electromagnetic actuator converges in a short period of time as illustrated in FIG. 17 by the sub-drive signal output from a certain control device, it can be readily inferred that the control device performs substantially the same processing as that of the control device 100 according to one embodiment (that is, the process of automatically changing the coefficients of the filter according to the frequency of the input signal) and substantially the same processing as that of the control device 100-2 according to another embodiment (that is, a process of measuring the resonance frequency with high accuracy).

Additionally, according to the control device 100 according to the embodiment, the brake can always be applied to the electromagnetic actuator 150 at a timing based on a predetermined timing (bottom timing, top timing, or cross timing) of the input signal regardless of the frequency of the input signal.

Therefore, for example, also when the sub-drive signal output from a certain control device can apply the brake to the electromagnetic actuator 150 at a timing based on a predetermined timing (bottom timing, top timing, or cross timing) of the input signal regardless of the frequency of the input signal (the detection signal of the strain sensor 154), it can be readily inferred that the control device performs substantially the same processing as that of the control device 100 according to one embodiment (that is, the process of automatically changing the coefficients of the filter according to the frequency of the input signal) and substantially the same processing as that of the control device 100-2 according to another embodiment (that is, a process of measuring the resonance frequency with high accuracy).

Additionally, according to the control device 100 according to the embodiment, the resonance frequency of the input signal can be measured with high accuracy, and thus the pulse width of one cycle of the sub-drive signal for applying the brake to the electromagnetic actuator 150 can be adjusted appropriately according to the resonance frequency of the input signal.

Therefore, for example, when the pulse width of one cycle of the sub-drive signal output from a certain control device is adjusted according to the resonance frequency of the input signal, it can be readily inferred that the control device performs substantially the same processing as that of the control device 100-2 according to another embodiment (that is, a process of measuring the resonance frequency with high accuracy).

Although the embodiments of the present invention have been described in detail above, the present invention is not limited to these embodiments, and various modifications and changes can be made within the scope of the present invention as set forth in the appended claims.

This international application claims priority to Japanese Patent Application Nos. 2024-024558 and 2024-024559, filed on February 21, 2024, the entire contents of which are incorporated herein by reference.

### Description of reference symbols

10 vibration generating device
100, 100-2 control device
120 signal processing circuit
121 low-pass filter
122 high-pass filter
123 phase compensation filter
124 filter coefficient changing section
124A calculating section
124B selector
124C memory
130 drive signal generator
140 driver
150 electromagnetic actuator
151 mover
152 plate-shaped elastic portion
153 coil
154 strain sensor (sensor)
160 frequency measuring circuit
161 filter
161A low-pass filter
161B high-pass filter
162 zero-cross detecting section
163 peak-and-bottom detecting section
164 selector
165 calculation period determining section
166 frequency calculating section
167 frequency update determining section

## Claims

1. A signal processing circuit comprising:
a filter configured to perform filter processing on an input signal; and
a filter coefficient changing section configured to automatically change a coefficient of the filter according to a frequency of the input signal.

2. The signal processing circuit as claimed in claim 1,
wherein the filter coefficient changing section includes a calculating section configured to calculate a changed coefficient by a polynomial function.

3. The signal processing circuit as claimed in claim 2,
wherein the calculating section calculates the changed coefficient by a first-order polynomial function.

4. The signal processing circuit as claimed in claim 2,
wherein the calculating section calculates the changed coefficient by a second-order polynomial function.

5. The signal processing circuit as claimed in claim 1,
wherein the filter coefficient changing section includes a selector configured to select, from among a plurality of coefficients stored in a memory, the coefficient corresponding to the frequency of the input signal as the changed coefficient.

6. The signal processing circuit as claimed in any one of claims 1 to 5, comprising a plurality of the filters,
wherein the filter coefficient changing section collectively changes respective coefficients of the plurality of filters.

7. A control device configured to control an actuator that applies vibration to an operation device based on an operation of the operation device, the control device comprising:
the signal processing circuit as claimed in claim 1,
wherein the input signal is a signal acquired by a sensor according to the vibration of the actuator.

8. The control device as claimed in claim 7,
wherein the signal processing circuit further includes a drive signal generator configured to generate a drive signal for braking the vibration of the actuator based on the input signal after the filter processing by the filter, and
wherein the drive signal generator generates the drive signal that always enables braking the vibration of the actuator at a predetermined timing regardless of the frequency of the input signal, by the coefficient of the filter being automatically changed according to the frequency of the input signal.

9. The control device as claimed in claim 8,
wherein the predetermined timing is a timing based on a peak timing, a bottom timing, or a zero-cross timing of the input signal.
